# EUROPEAN PATENT APPLICATION

(11) **EP 3 489 993 A1**
(43) Date of publication of application: **29.05.2019**
(21) Application number: 16909934.8
(22) Date of filing: 25.07.2016
(51) Int. Cl.: H01L 21/77, G02F 1/1362

(54) **METHOD FOR MANUFACTURING ARRAY SUBSTRATE**

(71) Applicant: Shenzhen Royole Technologies Co., Ltd., Shenzhen, Guangdong 518172 (CN)
(72) Inventor: YUAN, Ze, Shenzhen Guangdong 518052 (CN); YU, Xiaojun, Shenzhen Guangdong 518052 (CN); GUPTA, Amit, Shenzhen Guangdong 518052 (CN); WEI, Peng, Shenzhen Guangdong 518052 (CN)
(74) Representative: Hamer, Christopher K.
(86) International application number: PCT/CN2016/091520
(87) International publication number: WO 2018/018351

(57) **Abstract**

A method for manufacturing an array substrate is provided. The method includes the following. A signal transmission line and a gate electrode are formed on an underlayment, and are separated with a gap therebetween. A gate insulation layer and an active layer are formed on the signal transmission line and the gate electrode. An organic insulation layer is formed on the gate insulation layer and the active layer. The organic insulation layer is patterned to form a penetration hole corresponding to the signal transmission line. Then the gate insulation layer is etched to expose the signal transmission line by using the patterned organic insulation layer as a mask. A first conductive layer is formed on the penetration hole to be electrically connected with the signal transmission line. In this method, the array substrate can be prepared only by four photomasks and one photomask process can be omitted compared with the related art, which can simplify the manufacturing process and reduce the manufacturing cost.

## Description

### TECHNICAL FIELD

The present disclosure relates to the field of semiconductor technology, and more particularly to a method for manufacturing an array substrate.

### BACKGROUND

Thin film transistors (TFTs) are widely used in electronic display devices such as liquid crystal displays (LCDs) and organic light-emitting diodes (OLEDs) as a switching element. The TFT generally includes a gate electrode, a gate insulation layer, an active layer, a source electrode, a drain electrode, and other parts. The active layer is a key structure for achieving the switching function of the TFT. The electrical-stability of the active layer is particularly important for electronic display devices with the TFT. However, when the active layer made of semiconductor material is in a plasma environment, its electrical-stability will be decreased. Generally, a barrier layer will be etched to prevent the active layer from contacting with plasma when preparing via holes for connection data lines or scanning voltage lines.

However, the adding of an etched barrier layer will increase the procedures of the production process. Meanwhile, a standard TFT manufacturing process includes at least five photomasks. As a result, the overall equipment investment is too large, the production process is complicated, and manufacturing costs increase accordingly. In addition, the etched barrier layer made from the inorganic material may also decrease the flexibility of the electronic display devices.

### SUMMARY

According to a first aspect, there is provided a method for manufacturing an array substrate, which includes the following.

A signal transmission line and a gate electrode are formed on an underlayment and the signal transmission line and the gate electrode are separated with a gap therebetween.

A gate insulation layer and an active layer are formed on the signal transmission line and the gate electrode.

An organic insulation layer is formed on the gate insulation layer and the active layer.

The organic insulation layer is patterned to form a penetration hole corresponding to the signal transmission line.

The gate insulation layer is etched by using the patterned organic insulation layer as a mask to expose the signal transmission line.

A first conductive layer is formed on the penetration hole to be electrically connected with the signal transmission line.

Based on the first aspect, in a first implementation of the first aspect, the method further includes the follows when the organic insulation layer is patterned to form the penetration hole corresponding to the signal transmission line. A blind hole corresponding to the active layer is formed.

The method further includes that the organic insulation layer is removed with a preset thickness, whereby the blind hole becomes a through hole to expose the active layer.

The method further includes the follows when the first conductive layer is formed on the penetration hole to be electrically connected with the signal transmission line. A second conductive layer is formed on the through hole to be electrically connected with the active layer; the second conductive layer is patterned to form a source electrode and a drain electrode.

Based on the first implementation of the first aspect, in a second implementation of the first aspect, the method further includes the follows when the first conductive layer is formed on the penetration hole to be electrically connected with the signal transmission line. The first conductive layer and the second conductive layer are connected electrically.

Based on the first implementation of the first aspect, in a third implementation of the first aspect, the first conductive layer and/or the second conductive layer is made of metal material.

Based on the first implementation of the first aspect, in a fourth implementation of the first aspect, the organic insulation layer is patterned to form the penetration hole corresponding to the signal transmission line and form the blind hole corresponding to the active layer as follows. A gray-scale mask is prepared on the organic insulation layer, the organic insulation layer is etched by using the prepared gray-scale mask as a mask to form the penetration hole and the blind hole, and the gray-scale mask is peeled off.

Based on the first aspect, in a fifth implementation of the first aspect, the organic insulation layer is formed on the gate insulation layer and the active layer as follows. A third conductive layer is formed on the active layer, the third conductive layer is patterned to form a source electrode and a drain electrode, and the organic insulation layer is formed on the gate insulation layer and the third conductive layer.

Based on the fifth implementation of the first aspect, in a sixth implementation of the first aspect, the method further includes the follows when the organic insulation layer is patterned to form the penetration hole corresponding to the signal transmission line. A blind hole corresponding to the source electrode or the drain electrode is formed.

The method further includes that the patterned organic insulation layer is removed with a preset thickness entirely whereby the blind hole becomes a through hole, to expose the source electrode or the drain electrode.

The method further includes the follows when the first conductive layer is formed on the penetration hole to electrically connect with the signal transmission line. A fourth conductive layer is formed on the through hole to be electrically connected with the source electrode or the drain electrode.

Based on the sixth implementation of the first aspect, in a seventh implementation of the first aspect, the method further includes the following when the first conductive layer is formed on the penetration hole to be electrically connected with the signal transmission line. The first conductive layer and the fourth conductive layer are connected electrically. The first conductive layer and/or the fourth conductive layer is made of transparent conductive material.

Based on the fifth implementation of the first aspect, in a eighth implementation of the first aspect, the organic insulation layer is patterned to form the penetration hole corresponding to the signal transmission line and the blind hole corresponding to the source electrode or the drain electrode as follows. A gray-scale mask is prepared on the organic insulation layer, the organic insulation layer is etched by using the prepared gray-scale mask as a mask to form the penetration hole and the blind hole, and the gray-scale mask is peeled off.

Based on the first aspect and the first to eighth implementations of the first aspect, in a ninth implementation of the first aspect, the signal transmission line and the gate electrode are formed on the underlayment as follows. A buffer layer is deposited on the underlayment. The signal transmission line and the gate electrode are formed on the buffer layer.

Compared to the related art, in the method for manufacturing an array substrate according to the disclosure, the signal transmission line and the gate electrode are formed on the underlayment, and are separated with the gap therebetween. The gate insulation layer and the active layer are formed on the signal transmission line and the gate electrode. The organic insulation layer is formed on the gate insulation layer and the active layer. The organic insulation layer is patterned to form the penetration hole corresponding to the signal transmission line and the gate insulation layer is etched by using the patterned organic insulation layer as a mask to expose the signal transmission line. The first conductive layer is formed on the penetration hole to be electrically connected with the signal transmission line. In this way, only four photomask processes are needed to complete the manufacturing of the array substrate. Obviously, one photomask process is omitted compared to the related art. Therefore, the production process can be simplified and the production cost can be saved accordingly; furthermore, the flexibility of the array substrate can be improved by using the organic insulation layer as the etched barrier layer.

Further, according to the method, a gray-scale lithography process is used to pattern the organic insulation layer to form the penetration hole corresponding to the signal transmission line and the blind hole corresponding to the active layer or the source electrode. Then the gate insulation layer is etched by using the patterned organic insulation layer as a mask to expose the signal transmission line. Further, the organic insulation layer is removed with the preset thickness to turn the blind hole into the through hole. The method only need one photomask process to complete the manufacturing of the penetration hole and the through hole, therefore the process is simplified. When etching, the damage of the active layer structure caused by contact between the plasma and the active layer or the source electrode can be avoided, meanwhile the conductivity between a pixel electrode and the source electrode or the drain electrode can be improved, and the performance of the manufactured array substrate can be improved accordingly.

### BRIEF DESCRIPTION OF THE DRAWINGS

In order to better illustrate the technical solutions embodied by the embodiments of the disclosure or by the related art, the accompanying drawings for use with description of the embodiments or the related art are briefly described below. It will be apparent that the drawings described in the following represent merely some embodiments of the disclosure, and that those of ordinary skill in the art will be able to obtain other drawings from these drawings without performing any creative work.
FIG.1 is a flow diagram illustrating a method for manufacturing an array substrate according to an embodiment of the disclosure.
FIG.2A - FIG.2F are schematic diagrams illustrating partial preparing steps of a method for manufacturing an array substrate according to an embodiment of the disclosure.
FIG.3A - FIG.3D are schematic diagrams illustrating partial preparing steps of a method for manufacturing an array substrate according to another embodiment of the disclosure.
FIG.4A - FIG.4F are schematic diagrams illustrating partial preparing steps of a method for manufacturing an array substrate according to yet another embodiment of the disclosure.
FIG.5 is a flow diagram illustrating a method for manufacturing an array substrate according to another embodiment of the disclosure.
FIG.6A - FIG.6F are schematic diagrams illustrating each preparing step of the method for manufacturing an array substrate in FIG.5.
FIG.7 is a flow diagram illustrating a method for manufacturing an array substrate according to yet another embodiment.
FIG.8A - FIG.8F are schematic diagrams illustrating each preparing step of the method for manufacturing an array substrate in FIG.7.

### DETAILED DESCRIPTION OF ILLUSTRATED EMBODIMENTS

In order to better illustrate the technical solutions of the embodiments of the disclosure, the accompanying drawings for use with description of the embodiments are briefly described below. It is evident that the embodiments described herein are merely some rather than all of the embodiments of the disclosure, and other embodiments obtained based on these embodiments without creative efforts by those skilled in the art shall all fall in the protection scope of the disclosure.

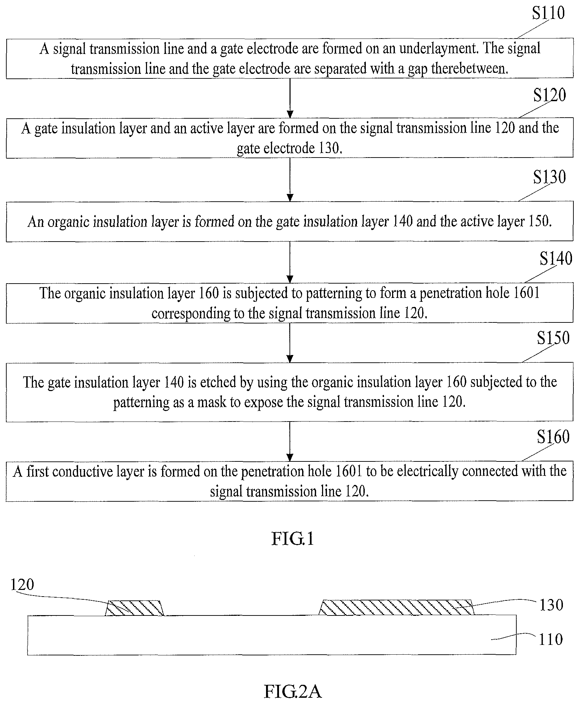

Referring to FIG.1, FIG.1 is a flow diagram illustrating a method for manufacturing an array substrate according to an embodiment of the disclosure. The method includes the following operations.

At S110, a signal transmission line and a gate electrode are formed on an underlayment. The signal transmission line and the gate electrode are separated with a gap therebetween.

Referring to FIG.2A together, an underlayment 110 is provided. A first metal layer is deposited on a surface of the underlayment. The first metal layer can be patterned to form a signal transmission line 120 and a gate electrode 130.

The first metal layer can be made of at least one material selected from a group consisting of Pt, Au, Al, Cu, Ti, Ag, Sc, Y, Cr, Ni, Mo, Al, and ITO.

At S120, a gate insulation layer and an active layer are formed on the signal transmission line 120 and the gate electrode 130.

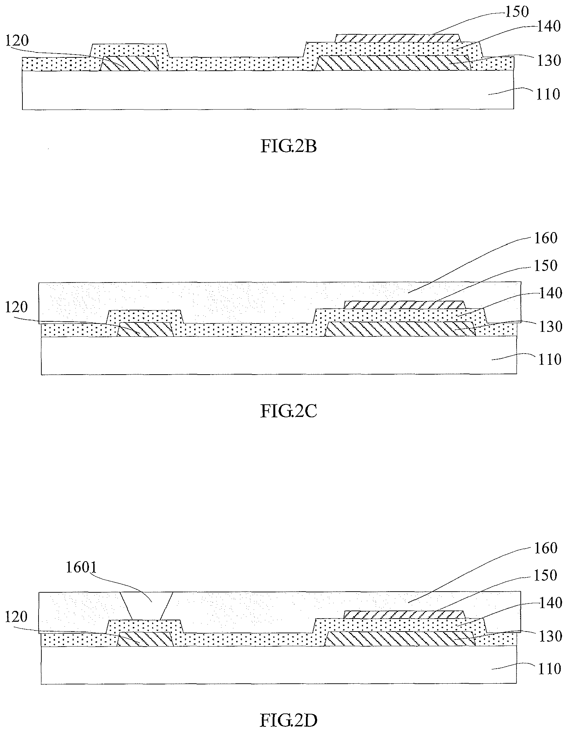

Referring to FIG.2B together, a gate insulation layer 140 can be made of at least one material selected from a group consisting of HfO₂, ZrO₂, Al₂O₃, SiO₂, and Si₃N₄. The gate insulation layer 140 is formed via a chemical vapor deposition process, an atomic layer deposition process, or a physical vapor deposition process.

An active layer 150 is formed on a surface of the gate insulation layer 140 away from the gate electrode 130. The active layer 150 corresponds to the gate electrode 130. In this embodiment, the active layer 150 includes a channel layer, a first doped region, and a second doped region. The first doped region and the second doped region are both in contact with the channel layer. The first doped region and the second doped region are separated with a gap therebetween. There are many methods for preparing the active layer 150 in the related art and will not be described herein.

At S130, an organic insulation layer is formed on the gate insulation layer 140 and the active layer 150.

Referring to FIG.2C together, an organic insulation layer 160 may be made of polymer material, and can be prepared through chemical vapor deposition, physical vapor deposition, or spin-coating.

At S140, the organic insulation layer 160 is patterned to form a penetration hole 1601 corresponding to the signal transmission line 120.

Referring to FIG.2D together, the organic insulation layer 160 is patterned through photomask and an etching process to form the penetration hole 1601 corresponding to the signal transmission line 120.

At S150, the gate insulation layer 140 is etched by using the organic insulation layer 160 patterned as a mask, to expose the signal transmission line 120.

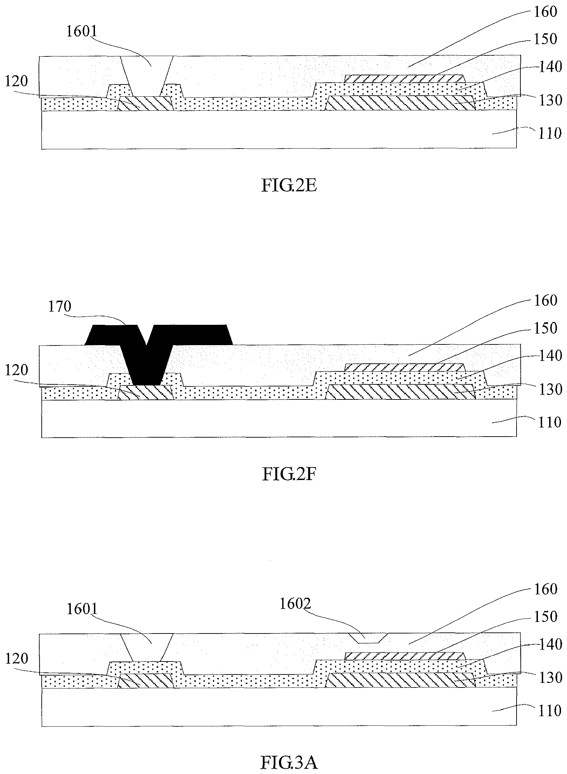

Referring to FIG.2E, through the etching process, the gate insulation layer 140 is etched, whereby a penetration hole 1601 penetrates through the gate insulation layer 140 to expose the signal transmission line 120.

At S160, a first conductive layer is formed on the penetration hole 1601 to be electrically connected with the signal transmission line 120.

Referring to FIG.2F together, a first conductive layer 170 is formed on the penetration hole 1601 and the organic insulation layer, to be electrically connected with the signal transmission line 120. The first conductive layer 170 may be made of transparent conductive thin-film material or metal thin-film material.

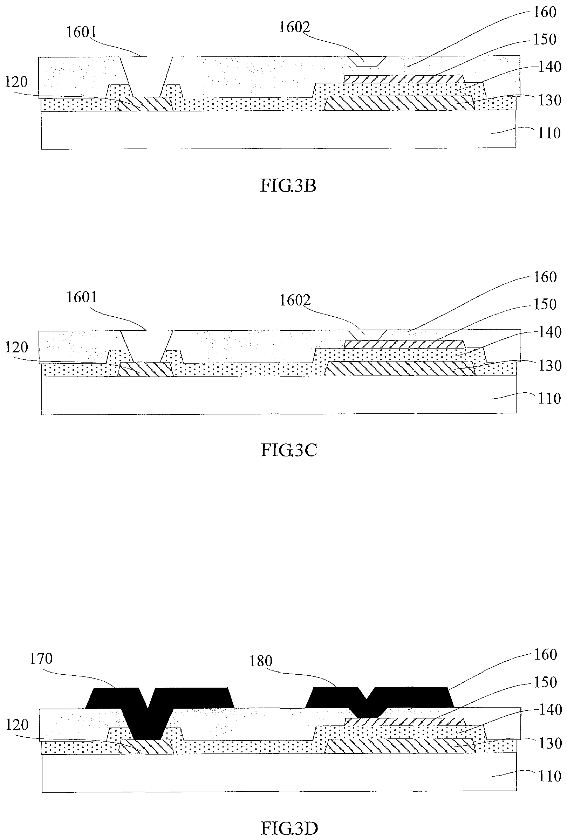

In this embodiment, the method further includes the follows when the organic insulation layer 160 is patterned to form the penetration hole 1601 corresponding to the signal transmission line. As illustrated in FIG.3A, a blind hole 1602 corresponding to the active layer 150 is formed. As illustrated in FIG.3B, the gate insulation layer 140 is etched by using the patterned organic insulation layer 160 as a mask to make the penetration hole 1601 penetrate through the gate insulation layer to expose the signal transmission line 120. The method further includes the following. The organic insulation layer 160 is removed with a preset thickness, whereby the blind hole 1602 becomes a through hole to expose the active layer 150, as illustrated in FIG.3C. The method further includes the following when the first conductive layer 170 is formed on the penetration hole to be electrically connected with the signal transmission line 120. A second conductive layer 180 is formed on the through hole to be electrically connected with the active layer 150. As illustrated in FIG.3D, the second conductive layer 180 is patterned to form a source electrode 1801 and a drain electrode 1802.

The blind hole 1602 includes one or two blind holes. For example, two blind holes are used, which can be arranged on both ends of the active layer.

The method further includes the following, when the first conductive layer 170 is formed on the penetration hole 1601 and is electrically connected with the signal transmission line 120, and the second conductive layer 180 is formed on the through hole and is electrically connected with the active layer 150. The first conductive layer 170 and the second conductive layer 180 are electrically connected. In particular, the first conductive layer 170 can be formed on the penetration hole 1601, the blind hole 1602, and the organic insulation layer. The first conductive layer 170 is electrically connected with the signal transmission line 120 and the active layer 150. The first conductive layer 170 is patterned to form the source electrode 1801 and the drain electrode 1802, where the source electrode 1802 is electrically connected to the signal transmission line 120.

Optionally, the first conductive layer and/or the second conductive layer is made of metal material.

Optionally, the organic insulation layer 160 is patterned to form the penetration hole 1601 corresponding to the signal transmission line 120 and the blind hole 1602 corresponding to the active layer 150 as follows. A gray-scale mask is prepared on the organic insulation layer 160, the organic insulation layer 160 is etched by using the prepared gray-scale mask as a mask to form the penetration hole 1601 and the blind hole 1602, and then the gray-scale mask is peeled off.

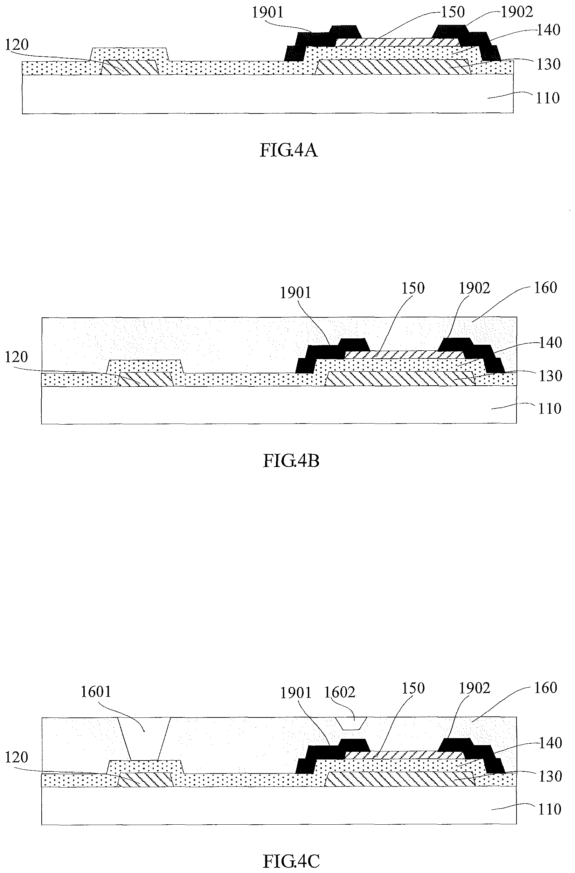

In this embodiment, operations at S130 can include the following. As illustrated in FIG.4A, a third conductive layer 190 is formed on the active layer 150. The third conductive layer 190 is patterned to form a source electrode 1901 and a drain electrode 1902. As illustrated in FIG.4B, the organic insulation layer 160 is formed on the gate insulation layer 140 and the third conductive layer 190.

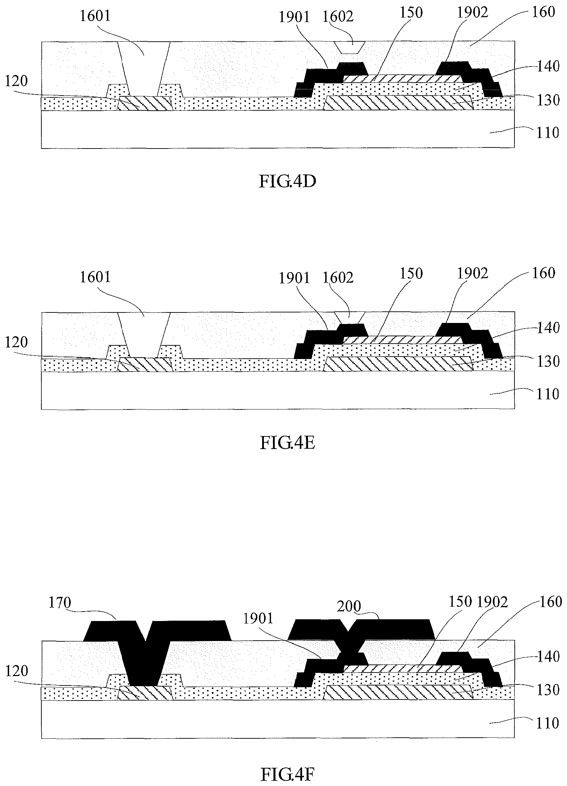

Optionally, operations at S140 may further include the following. As illustrated in FIG.4C, the blind hole 1602 is formed corresponding to the source electrode 1901 or the drain electrode 1902. As illustrated in FIG.4D, the gate insulation layer 140 is etched by using the patterned organic insulation layer 160 as a mask, to make the penetration hole 1601 penetrate through the gate insulation layer to expose the signal transmission line 120. The method further includes the following. The patterned organic insulation layer 160 is removed with a preset thickness, to turn the blind hole 1602 into the through hole to expose the source electrode 1901 or the drain electrode 1902, as illustrated in FIG.4E. Operations at S160 may further include the following. A fourth conductive layer 200 is formed on the through hole to be electrically connected with the source electrode 1901 or the drain electrode 1902, as illustrated in FIG.4F.

It is to be noted that operations at S160 may further include the following. The first conductive layer 170 and the fourth conductive layer 200 are electrically connected, where the first conductive layer 170 and the fourth conductive layer 200 are made of transparent conductive materials.

Optionally, the organic insulation layer 160 is patterned to form the penetration hole 1601 corresponding to the signal transmission line 120 and the blind hole 1602 corresponding to the source electrode 1901 or the drain electrode 1902 as follows. A gray-scale mask is prepared on the organic insulation layer 160, the organic insulation layer 160 is etched by using the prepared gray-scale mask as a mask to form the penetration hole 1601 and the blind hole 1602, and the gray-scale mask is peeled off.

In this embodiment, operations at S110 may further include the following. A buffer layer 210 is deposited on the underlayment. The signal transmission line 120 and the gate electrode are formed on the buffer layer 210.

Compared with the related art, according to the method for manufacturing an array substrate, the signal transmission line and the gate electrode are formed on the underlayment. The signal transmission line and the gate electrode are separated with the gap therebetween. The gate insulation layer and the active layer are formed on the signal transmission line and the gate electrode. The organic insulation layer is formed on the gate insulation layer and the active layer. The organic insulation layer is patterned to form the penetration hole corresponding to the signal transmission line. The gate insulation layer is etched by using the patterned organic insulation layer as a mask to expose the signal transmission line. The first conductive layer is formed on the penetration hole to be electrically connected with the signal transmission line. In this way, only four photomask processes are needed to complete the manufacturing of the array substrate, and one photomask process is omitted compared to the related art. Therefore, the production process may be simplified and the production cost may be saved accordingly. Furthermore, flexibility of the array substrate can be improved by using the organic insulation layer as the etched barrier layer.

Further, according to the method, the gray-scale lithography process is used to pattern the organic insulation layer to form the penetration hole corresponding to the signal transmission line and the blind hole corresponding to the active layer or the source electrode. Then the gate insulation layer is etched by using the patterned organic insulation layer as a mask to expose the signal transmission line. Further, the integral organic insulation layer is removed with the preset thickness to turn the blind hole into the through hole. According to this method, only one photomask process is needed to complete the manufacturing of the penetration hole and the through hole and therefore, the process can be simplified. When etching, damage of the structure of the active layer caused by contact between the plasma and the active layer or the source electrode can be avoided, meanwhile, conductivity between a pixel electrode and the source electrode or the drain electrode can be improved, so as to improve the performance of the manufactured array substrate.

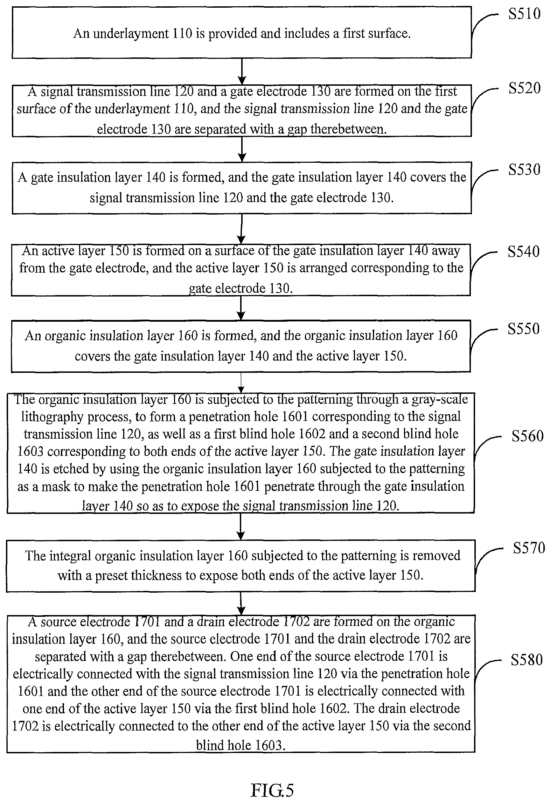

Refer to FIG.5. FIG.5 is a flow diagram illustrating a method for manufacturing an array substrate according to an embodiment of the disclosure. The method includes the following.

At S510, an underlayment 110 is provided. The underlayment 110 includes a first surface.

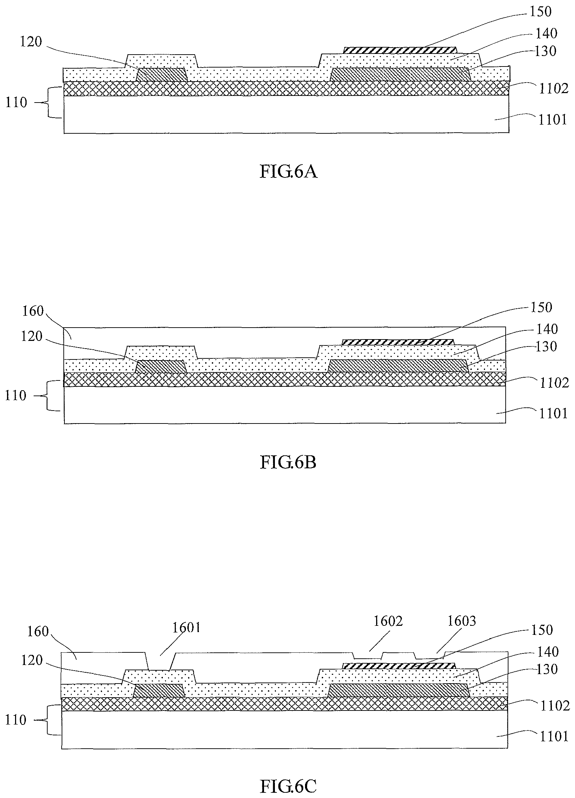

In this implementation, as illustrated in FIG.6A, the underlayment 110 can include a substrate 1101 and a buffer layer 1102. The underlayment 110 can be prepared as follows. A substrate 1101 is provided and a buffer layer 1102 is formed on a surface of the substrate 1101. The buffer layer 1102 can be made of flexible polymer material, or inorganic material such as SiOx, and SiNx, and can be deposited on the substrate 1101 via a chemical vapor deposition process or a spin-coating process.

At S520, a signal transmission line 120 and a gate electrode 130 are formed on the first surface of the underlayment 110; the signal transmission line 120 and the gate electrode 130 are separated with a gap therebetween, as illustrated in FIG.6A.

In this implementation, operations at S520 can include the following.

At S521, a first metal layer is deposited on the first surface of the underlayment 110.

At S522, a first photoresist layer is coated on a surface of the first metal layer away from the underlayment.

At S523, the first photoresist layer is patterned and a part of the first photoresist layer covering the first surface is removed.

At S524, plasma etching is performed on the first metal layer by using the remaining first photoresist layer as a mask. The signal transmission line 120 and the gate electrode 130 are two metal layers arranged on the underlayment at intervals.

At S525, the remaining first photoresist layer is peeled off. In this embodiment, the remaining first photoresist layer can be peeled off by organic solvent, such as acetone.

It is understood that the first metal layer can be made of at least one material selected from a group consisting of Pt, Au, Al, Cu, Ti, Ag, Sc, Y, Cr, Ni, Mo, Al, and ITO. The first metal layer can be formed by thermal evaporation, electron beam evaporation or sputtering, and the first photoresist layer is patterned via a photomask process.

At S530, a gate insulation layer 140 is formed. The gate insulation layer 140 covers the signal transmission line 120 and the gate electrode 130. Referring to FIG.6A, the gate insulation layer 140 is made from at least one material selected from a group consisting of HfO₂, ZrO₂, Al₂O₃, SiO₂, and Si₃N₄. The gate insulation layer 140 can be formed via a chemical vapor deposition process, an atomic layer deposition (ALD) process, or a physical vapor deposition (PVD) process.

At S540, an active layer 150 is formed on a surface of the gate insulation layer 140 away from the gate electrode. The active layer 150 is arranged corresponding to the gate electrode 130. In this embodiment, the active layer 150 includes a channel layer, a first doped region, and a second doped region. The first doped region and the second doped zone are both in contact with the channel layer. The first doped region and the second doped zone are separated with a gap therebetween. Another photomask process is used in the process of preparing of the active layer. The active layer is well known in the related art and will not be described herein.

At S550, an organic insulation layer 160 is formed. The organic insulation layer 160 covers the gate insulation layer 140 and the active layer 150. As illustrated in FIG.6B, the organic insulation layer 160 can be made of polymer material. The organic insulation layer 160 can be formed through chemical vapor deposition, physical vapor deposition, or spin-coating.

At S560, the organic insulation layer 160 is patterned through a gray-scale lithography process, to form a penetration hole 1601 corresponding to the signal transmission line 120 as well as a first blind hole 1602 and a second blind hole 1603 corresponding to both ends of the active layer 150. The gate insulation layer 140 is etched by using the patterned organic insulation layer 160 as a mask to make the penetration hole 1601 penetrate through the gate insulation layer 140, so as to expose the signal transmission line 120.

In this implementation, operations at S560 include the following.

At S561, a gray-scale mask is prepared on the organic insulation layer 160.

At S562, referring to FIG.6C, a first etching is performed on the organic insulation layer by using the prepared gray-scale mask as a mask to form the penetration hole 1601, the first blind hole 1602, and the second blind hole 1603.

At S563, the gray-scale mask is peeled off.

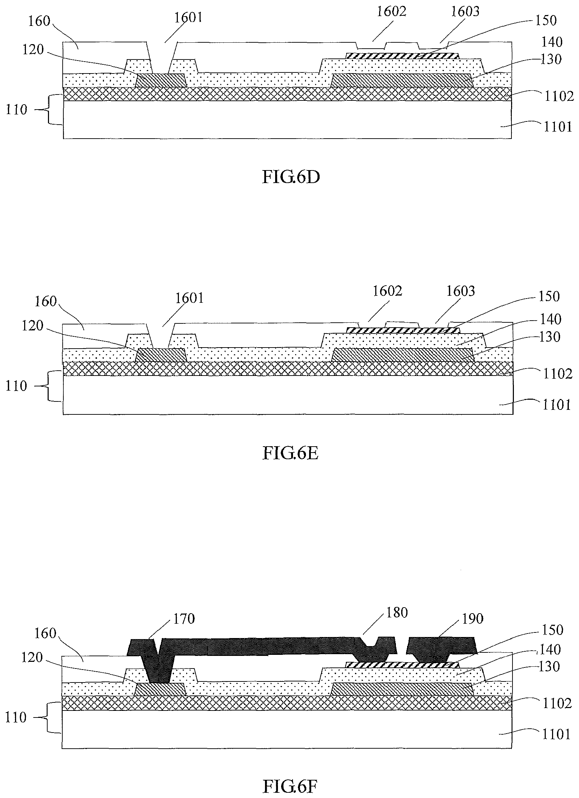

At S564, as illustrated in FIG.6D, a second etching is performed by using the patterned organic insulation layer 160 as a mask to make the penetration hole 1601 penetrate through the gate insulation layer 140.

At S570, the patterned integral organic insulation layer 160 is removed with a preset thickness to expose both ends of the active layer 150, as illustrated in FIG.6E.

In this implementation, operations at S570 include the following.

The patterned organic insulation layer 160 is etched. The organic insulation layer is peeled off with the preset thickness to expose both ends of the active layer 150. In this implementation, peeling off the organic insulation layer with the preset thickness can be performed through a wet etching method.

The first etching in S560 can be achieved via wet etching and the second etching in S570 can be achieved via dry etching. Still another photomask process is used in S561. In S560 and S570, one photomask process and two etching processes are used to form the penetration hole 1601, the first blind hole 1602, and the second blind hole 1603. Compared with the related art, according to this method, one photomask process is omitted in a premise of preventing the active layer in the first etching from contacting with the plasma, therefore, it is possible to simplify the production process and save cost.

At S580, a source electrode 1701 and a drain electrode 1702 are formed on the organic insulation layer 160. The source electrode 1701 and the drain electrode 1702 are separated with a gap therebetween. One end of the source electrode 1701 is electrically connected with the signal transmission line 120 via the penetration hole 1601 and the other end of the source electrode 1701 is electrically connected with one end of the active layer 150 via the first blind hole 1602. The drain electrode 1702 is electrically connected to the other end of the active layer 150 via the second blind hole 1603. As illustrated FIG.6F, the source electrode 1701 or the drain electrode 1702 is made from at least one material selected from a group consisting of Pt, Au, Al, Cu, Ti, Ag, Sc, Y, Cr, Ni, Mo, Al, and ITO.

In this implementation, operations at S580 include the following.

At S581, a first conductive layer is formed on a surface of the organic insulation layer away from the gate insulation layer. The first conductive layer is made from at least one material selected from a group consisting of Pt, Au, Al, Cu, Ti, Ag, Sc, Y, Cr, Ni, Mo, Al, and ITO.

At S582, a second photoresist layer is coated on a surface of the first conductive layer away from the organic insulation layer 160.

At S583, the second photoresist layer is patterned, and a part of the second photoresist layer covering the middle part of the active layer 150 is removed.

At S584, plasma etching is performed on the first conductive layer by using the remaining second photoresist layer as a mask, to form the source electrode 1701 and the drain electrode 1702.

At S585, the remaining second photoresist layer is peeled off.

It will be appreciated that the signal transmission line 120 and the source electrode 1701 can be mutually connected via an external pin. Alternatively, the signal transmission line 120 and the drain electrode 1702 can be mutually connected via an external pin. A further photomask process is used in S583. As can be seen, in the method for manufacturing an array substrate of the present disclosure, four photomask processes are used, and compared with the related art in which at least five photomask processes are used, one photomask process is omitted and therefore, the production process can be simplified and the manufacturing cost can be reduced.

It is to be noted that, "etching" referred to herein may include drying etching and wet etching. Gas used in drying etching may be CF4, SF6, or a gas mixture of CL2 and 02. Liquid used in wet etching may be oxalic acid, sulfuric acid, hydrochloric acid, or the mixture of oxalic acid, sulfuric acid, and hydrochloric acid.

In this disclosure, "patterning" refers to a composition process, which can include a lithography process, or include a lithography process and etching operations; besides, the composition process may further include printing, inkjet, and other processes for forming a predetermined pattern. The lithography process refers to a process of forming a pattern by using a photoresist, a mask plate, an exposure machine and the like in film formation, exposure, development, and other processes. Corresponding composition process can be selected according to the structure formed in the present disclosure.

According to the embodiments of the present disclosure, display devices formed through the method for manufacturing an array substrate may be liquid crystal panels, LCD TVs, LCDs, OLED Panels, OLED TVs, electronic paper, digital photo frames, mobile phones, and the like.

Compared with the related art, according to the method for manufacturing an substrate array of the disclosure, the organic insulation layer covering the gate insulation layer and the active layer is patterned through a gray-scale lithography process, to form the penetration hole corresponding to the signal transmission line as well as the first blind hole and the second blind hole corresponding to both ends of the active layer. The gate insulation layer is etched by using the patterned organic insulation layer as a mask to expose the signal transmission line. Further, the integral patterned organic insulation layer is removed by the preset thickness to expose the source electrode and the drain electrode. With aid of this method, only one photomask process is required to complete via holes between the pixel electrodes and the signal transmission line and via holes between the source electrode and the drain electrode. Compared with the related art, one photomask process is omitted, therefore, it is possible to simplify the production process and save the manufacturing cost. Furthermore, flexibility of the array substrate can be improved by using the organic insulation layer as the etched barrier layer.

When plasma etching is performed on the gate insulation layer, the first blind hole and the second blind hole are not intercommunicated with the active layer, and the organic insulation layer of a certain thickness is disposed between the first blind hole/the second blind hole and the active layer; therefore, the active layer can be protected from the plasma, thus improving the electrical-stability of the active layer and the performance of the manufactured array substrate.

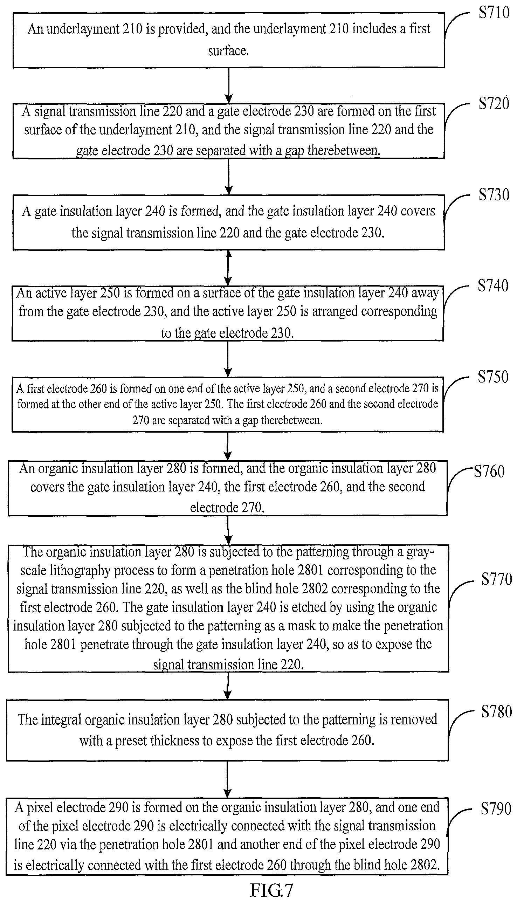

Referring to FIG.7, FIG.7 is a flow diagram illustrating a method for manufacturing an array substrate according to yet another embodiment. The method includes the following.

At S710, an underlayment 210 is provided. The underlayment 210 includes a first surface.

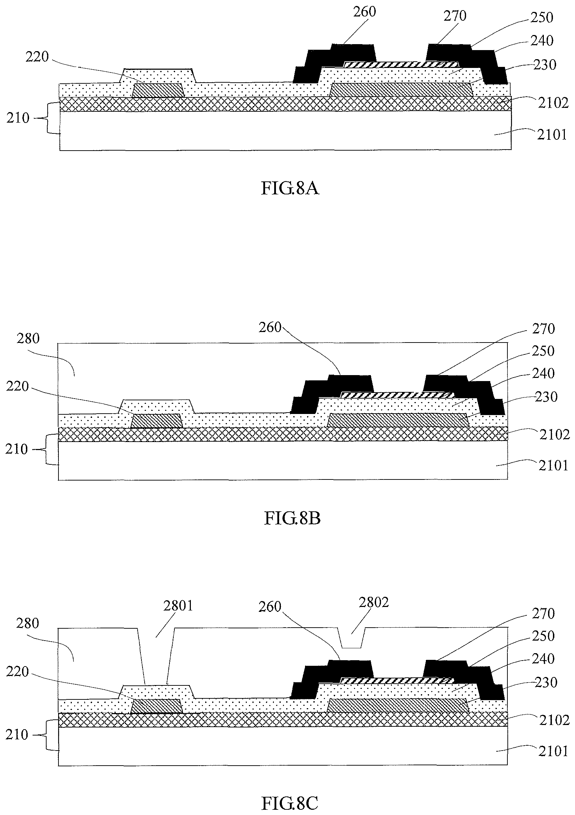

In this implementation, the underlayment 210 can include a substrate 2101 and a buffer layer 2102. As illustrated in FIG.8A, the preparing method of the underlayment 210 can be achieved as follows. A substrate 2101 is provided and a buffer layer 2102 is formed on a surface of the substrate 2101. The buffer layer 2102 can be made of flexible polymer material or inorganic material such as SiOx, SiNx, and the like. The buffer layer 2102 can be deposited on the substrate 2101 via a chemical vapor deposition process or a spin-coating process. A signal transmission line referred in the following can be a data line or a voltage line.

At S720, a signal transmission line 220 and a gate electrode 230 are formed on the first surface of the underlayment 210. The signal transmission line 220 and the gate electrode 230 are separated with a gap therebetween, as illustrated in FIG.8A. The signal transmission line 220 and/or the gate electrode 230 can be made of at least one material selected from a group consisting of Pt, Au, Al, Cu, Ti, Ag, Sc, Y, Cr, Ni, Mo, Al, and ITO.

In the implementation, operations at S720 include the following.

At S721, a first metal layer is deposited on the first surface of the underlayment 210.

At S722, a first photoresist layer is coated on a surface of the first metal layer away from the underlayment 210.

At S723, the first photoresist layer is patterned, and a part of the first photoresist layer covering the first surface is removed.

At S724, plasma etching is performed on the first metal layer by using the remaining first photoresist layer as a mask. Two metal layers, that is, the signal transmission line 220 and the gate electrode 230, are arranged on the underlayment 210 at intervals.

At S725, the remaining first photoresist layer is peeled off. In the implementation, the remaining first photoresist layer can be peeled off by organic solvent, such as acetone.

The first metal layer can be made from at least one material selected from a group consisting of Pt, Au, Al, Cu, Ti, Ag, Sc, Y, Cr, Ni, Mo, Al, and ITO. The first metal layer can be formed via thermal evaporation, electron beam evaporation, or sputtering. The first photoresist layer is patterned by using a first photomask process.

At S730, a gate insulation layer 240 is formed. The gate insulation layer 240 covers the signal transmission line 220 and the gate electrode 230. As illustrated in FIG.9, the gate insulation layer 240 can be made from at least one material selected from a group consisting of HfO₂, ZrO₂, Al₂O₃, SiO₂, and Si₃N₄. The gate insulation layer 240 can be formed via a chemical vapor deposition process, an atomic layer deposition process, or a physical vapor deposition process.

At S740, an active layer 250 is formed on a surface of the gate insulation layer 240 away from the gate electrode 230. The active layer 250 is arranged corresponding to the gate electrode 230. As illustrated in FIG.8A, in this embodiment, the active layer 250 includes a channel layer, a first doped region, and a second doped region. The first doped region and the second doped zone are both in contact with the channel layer. The first doped region and the second doped zone are separated with a gap therebetween. A second photomask process is used in the preparation of the active layer. The active layer is well known in the related art and will not be detailed herein.

At S750, a first electrode 260 is formed on one end of the active layer 250, and a second electrode 270 is formed at the other end of the active layer 250. The first electrode 260 and the second electrode 270 are separated with a gap therebetween. As illustrated in FIG.8A, the first electrode 260 acts as a source electrode and the second electrode 270 acts as a drain electrode. Alternatively, the first electrode 260 acts as a drain electrode and the second electrode 270 acts as a source electrode.

In this implementation, operations at S750 include the following.

At S751, a second metal layer is formed. The second metal layer covers a surface of the gate insulation layer 240 away from the underlayment 210 and a surface of the active layer 250 away from the gate insulation layer 240.

At S752, a second photoresist layer is coated on a surface of the second metal layer away from gate insulation layer 240.

At S753, the second photoresist layer is patterned and a part of the second photoresist layer covering the middle part of the active layer 250 is removed.

At S754, the second metal layer is etched by using the remaining second photoresist layer as a mask to form the first electrode 260 and the second electrode 270. A second metal layer arranged on one end of the active layer 250 adjacent to the signal transmission line 220 is the first electrode 260. A second metal layer arranged on the other end of the active layer 250 away from the signal transmission line 220 is the second electrode 270.

At S755, the remaining second photoresist layer is peeled off.

The second metal layer is made from at least one material selected from a group consisting of Pt, Au, Al, Cu, Ti, Ag, Sc, Y, Cr, Ni, Mo, Al, and ITO. The second metal layer can be etched by wet etching and/or dry etching. A third photomask process is used in S753.

At S760, an organic insulation layer 280 is formed. The organic insulation layer 280 covers the gate insulation layer 240, the first electrode 260, and second electrode 270. Referring to FIG.8B, the organic insulation layer 280 can be made of polymer material, and can be formed via chemical vapor deposition, physical vapor deposition, or spin-coating.

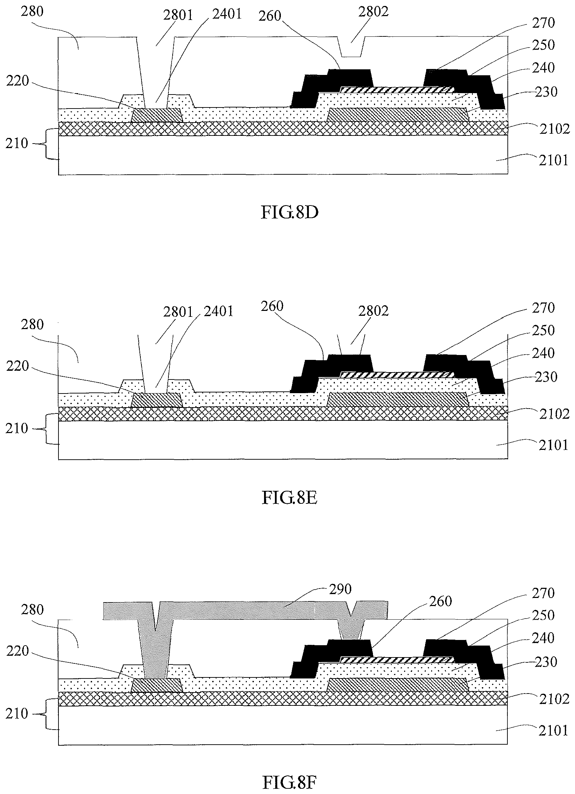

At S770, the organic insulation layer 280 is patterned through a gray-scale lithography process to form a penetration hole 2801 corresponding to the signal transmission line 220 as well as a blind hole 2802 corresponding to the first electrode 260. The gate insulation layer 240 is etched by using the patterned organic insulation layer 280 as a mask to make the penetration hole 2801 penetrate through the gate insulation layer 240, so as to expose the signal transmission line 220, as illustrated in FIG.8C and FIG.8D.

In this implementation, operations at S770 include the following.

At S771, a gray-scale mask is prepared on the organic insulation layer 280.

At S772, referring to FIG.8C, a first etching is performed on the organic insulation layer 280 by using the prepared gray-scale mask as a mask to form the penetration hole 2801 and the second blind hole 2802.

At S773, the gray-scale mask is peeled off.

At S774, as illustrated in FIG.8D, a second etching is performed by using the patterned organic insulation layer 280 as a mask to make the penetration hole 2801 penetrate through the gate insulation layer 240.

At S780, the patterned integral organic insulation layer 280 is removed with a preset thickness to expose the first electrode 260, as illustrated in FIG.8E.

In this implementation, operations at S780 include the following.

The patterned organic insulation layer 280 is etched; the organic insulation layer 280 is peeled off with the preset thickness to expose the first electrode 260. In this implementation, the organic insulation layer can be peeled off with the preset thickness via wet etching.

The first etching in S772 can be achieved via wet etching and the second etching in S774 can be achieved via dry etching. A fourth photomask process is used in S771. In S770 and S780, one photomask process and two etching processes are used to form the penetration hole 2801 for connecting a pixel electrode and the signal transmission line 220 as well as the blind hole 2802 for respectively connecting the pixel electrode and the first electrode 260 or the second electrode 270. Compared with the related art, one photomask process is omitted in a premise of protecting the first electrode from being etched in the first etching, therefore, it is possible to simplify the manufacturing process and save cost.

At S790, referring to FIG.8F, a pixel electrode 290 is formed on the organic insulation layer 280. One end of the pixel electrode 290 is electrically connected with the signal transmission line 220 via the penetration hole 2801 and another end of the pixel electrode 290 is electrically connected with the first electrode 260 via the blind hole 2802.

In this implementation, operations at S790 include the following.

At S791, a transparent conductive layer is formed on a surface of the organic insulation layer 280 away from the gate insulation layer 240.

At S792, a third photoresist layer is coated on a surface of the transparent conductive layer away from the organic insulation layer 280.

At S793, the third photoresist layer is patterned and a part of the third photoresist layer covering the middle part of the active layer 250 is removed.

At S794, the transparent conductive layer is etched by using the remaining third photoresist layer as a mask to form the pixel electrode 290. The pixel electrode 290 is electrically connected to the signal transmission line 220 through the first via hole and is electrically connected to the first electrode 260 through the blind hole 2802.

At S795, the remaining third photoresist layer is peeled off.

It is to be noted that, "etching" referred to herein include drying etching and wet etching. Gas used in drying etching may be CF4, SF6, or a gas mixture of CL2 and O2. Liquid used in wet etching may be oxalic acid, sulfuric acid, hydrochloric acid, or the mixture of oxalic acid, sulfuric acid, and hydrochloric acid.

In this disclosure, "patterning" refers to a composition process, which can include a lithography process, or include a lithography process and etching operations; besides, the composition process may further include printing, inkjet, and other processes for forming a predetermined pattern. The lithography process refers to a process of forming a pattern by using a photoresist, a mask plate, an exposure machine and the like in film formation, exposure, development, and other processes. The corresponding composition process can be selected according to the structure formed in the present disclosure.

According to the embodiments of the present disclosure, display devices formed through the method for manufacturing an array substrate may be liquid crystal panels, LCD TVs, LCDs, OLED Panels, OLED TVs, electronic paper, digital photo frames, mobile phones, and the like.

Compared with the related art, according to the method for manufacturing an substrate array of the disclosure, the organic insulation layer covering the gate insulation layer, the source electrode and the drain electrode is patterned through a gray-scale lithography process to form the penetration hole corresponding to the signal transmission line as well as the blind hole corresponding to the source electrode or the drain electrode. Then, the gate insulation layer is etched by using the patterned organic insulation layer as a mask to expose the signal transmission line. Further, the patterned integral organic insulation layer is removed with the preset thickness to expose the first electrode. According to this method, only one photomask process can be used to complete the formation of the penetration hole for connecting the pixel electrode and the signal transmission line as well as the blind hole for connecting the pixel electrode and the source electrode or the drain electrode. Compared with the related art, one photomask process is omitted, therefore simplifying the production process, and saving the manufacturing cost. Furthermore, the flexibility of the array substrate can be improved by using the organic insulation layer as the etched barrier layer.

When plasma etching is performed on the gate insulation layer, the blind hole is not connected with the source electrode or the drain electrode, and the organic insulation layer is covering the source electrode or the drain electrode. In this way, the source electrode or the drain electrode cannot be affected by the plasma, thereby improving the conductivity between the pixel electrode and the source electrode or the drain electrode, further improving the performance of the manufactured array substrate.

The technical terms used in the embodiments of the present disclosure are merely used to describe some embodiments and are not intended to limit the present disclosure. As used herein, the singular forms "a", "an", and "the" are intended to include the plural forms as well, unless the context clearly indicates other cases. Further, the use of "including" and/or "comprising" when used in the specification means that the features, integers, steps, operations, elements and/or components are present but do not preclude the presence or addition of one or more other features, integers, steps, operations, elements, and/or components.

The corresponding structures, materials, acts, and equivalents of all means or steps, and function elements, if any, in the appended claims are intended to include any structure, material, or act for performing the function in combination with other explicitly claimed elements. The description of the present disclosure has been presented for purposes of illustration and description, but is not intended to be exhaustive or limited to the disclosure in the form disclosed. Many modifications and variations will be apparent to those skilled in the art without departing from the scope and spirit of the disclosure. The embodiments described in the present disclosure can better understand the principle and practical application of the present disclosure and make those skilled in the art understand the present disclosure.

The flowchart described in the present disclosure is merely an example and various modifications may be made to this illustration or the steps in the present disclosure without departing from the spirit of the present disclosure. For example, these steps can be executed in different orders, or some steps can be added, deleted, or modified. Those of ordinary skill in the art can understand that all or part of the procedures for implementing the foregoing embodiments and equivalent variations made according to the claims of the present disclosure still fall in the scope of the present disclosure.

## Claims

1. A method for manufacturing an array substrate, comprising:
forming a signal transmission line and a gate electrode on an underlayment, the signal transmission line and the gate electrode being separated with a gap therebetween;
forming a gate insulation layer and an active layer on the signal transmission line and the gate electrode;
forming an organic insulation layer on the gate insulation layer and the active layer;
patterning the organic insulation layer to form a penetration hole corresponding to the signal transmission line;
etching the gate insulation layer to expose the signal transmission line by using the organic insulation layer subjected to patterning as a mask; and
forming a first conductive layer on the penetration hole to be electrically connected with the signal transmission line.

2. The method of claim 1, wherein the patterning the organic insulation layer to form a penetration hole corresponding to the signal transmission line further comprises:
forming a blind hole corresponding to the active layer;
wherein the method further comprises:
removing the organic insulation layer with a preset thickness, whereby the blind hole becomes a through hole to expose the active layer;
wherein the forming a first conductive layer on the penetration hole to be electrically connected with the signal transmission line further comprises:
forming a second conductive layer on the through hole to be electrically connected with the active layer; and
patterning the second conductive layer to form a source electrode and a drain electrode.

3. The method of claim 2, wherein the forming a first conductive layer on the penetration hole to be electrically connected with the signal transmission line and forming a second conductive layer on the through hole to be electrically connected with the active layer further comprises:
connecting electrically the first conductive layer with the second conductive layer.

4. The method of claim 2, wherein at least one of the first conductive layer and the second conductive layer is made of metal material.

5. The method of claim 2, wherein the patterning the organic insulation layer to form a penetration hole corresponding to the signal transmission line and forming a blind hole corresponding to the active layer comprises:
preparing a gray-scale mask on the organic insulation layer;
etching the organic insulation layer by using the gray-scale mask prepared as a mask to form the penetration hole and the blind hole; and
peeling off the gray-scale mask.

6. The method of claim 1, wherein the forming an organic insulation layer on the gate insulation layer and the active layer comprises:
forming a third conductive layer on the active layer;
patterning the third conductive layer to form a source electrode and a drain electrode; and
forming the organic insulation layer on the gate insulation layer and the third conductive layer.

7. The method of claim 6, wherein the patterning the organic insulation layer to form a penetration hole corresponding to the signal transmission line further comprises:
forming a blind hole corresponding to the source electrode or the drain electrode;
wherein the method further comprises:
removing the organic insulation layer subjected to patterning with a preset thickness, whereby the blind hole becomes a through hole to expose the source electrode or the drain electrode;
wherein the forming a first conductive layer on the penetration hole to be electrically connected with the signal transmission line further comprises:
forming a fourth conductive layer on the through hole to be electrically connected with the source electrode or the drain electrode.

8. The method of claim 7, wherein the forming a first conductive layer on the penetration hole to be electrically connected with the signal transmission line further comprises:
connecting electrically the first conductive layer with the fourth conductive layer, the first conductive layer and the fourth conductive layer being made of transparent conductive materials.

9. The method of claim 7, wherein the patterning the organic insulation layer to form a penetration hole corresponding to the signal transmission line and forming a blind hole corresponding to the source electrode or the drain electrode comprises:
preparing a gray-scale mask on the organic insulation layer;
etching the organic insulation layer by using the gray-scale mask prepared as a mask to form the penetration hole and the blind hole; and
peeling off the gray-scale mask.

10. The method of any of claims 1-9, wherein the forming a signal transmission line and a gate electrode on an underlayment comprises:
depositing a buffer layer on the underlayment; and
forming the signal transmission line and the gate electrode on the buffer layer.
